Europäisches Patentamt

European Patent Office

Office européen des brevets

(11) Publication number: **0 502 428 A2**

# EUROPEAN PATENT APPLICATION

(21) Application number: **92103405.4**

(22) Date of filing: **27.02.92**

(51) Int. Cl.⁵: **H03M 1/12**

(30) Priority: **27.02.91 JP 31269/91**

(43) Date of publication of application:
**09.09.92 Bulletin 92/37**

(84) Designated Contracting States:
**DE FR GB NL**

(71) Applicant: **NEC CORPORATION**
**7-1, Shiba 5-chome Minato-ku**
**Tokyo 108-01(JP)**

(72) Inventor: **Kumagai, Toshiyuki, c/o NEC**
**Corporation**
**7-1, Shiba 5-chome**
**Minato-ku, Tokyo(JP)**

(74) Representative: **Betten & Resch**
**Reichenbachstrasse 19**
**W-8000 München 5(DE)**

(54) **Analog/digital converter.**

(57) In A/D converter with a plurality of analog input terminals (1-1), A/D conversion of a particular analog input terminal is performed predominantly, thereby reducing the period from the instant when A/D conversion request is generated to the instant when the converted value is obtained.

The A/D converter in accordance with the invention is comprised of first and second terminal selecting sections 1-2 and 1-3 which may separately be set, corresponding first and second conversion result storage registers, a control unit 1-4, a single A/D conversion unit 1-6 and the like. By this arrangement, a terminal to be A/D converted is imparted with a priority and a desired analog input terminal has a definite timing of A/D conversion start, and the period required to obtain the converted value is reduced.

## FIG.3

EP 0 502 428 A2

The present invention relate to a hardware arrangement of an analog/digital converter (hereinafter referred to as A/D converter), and more particularly to an operational sequence to be performed by the hardware.

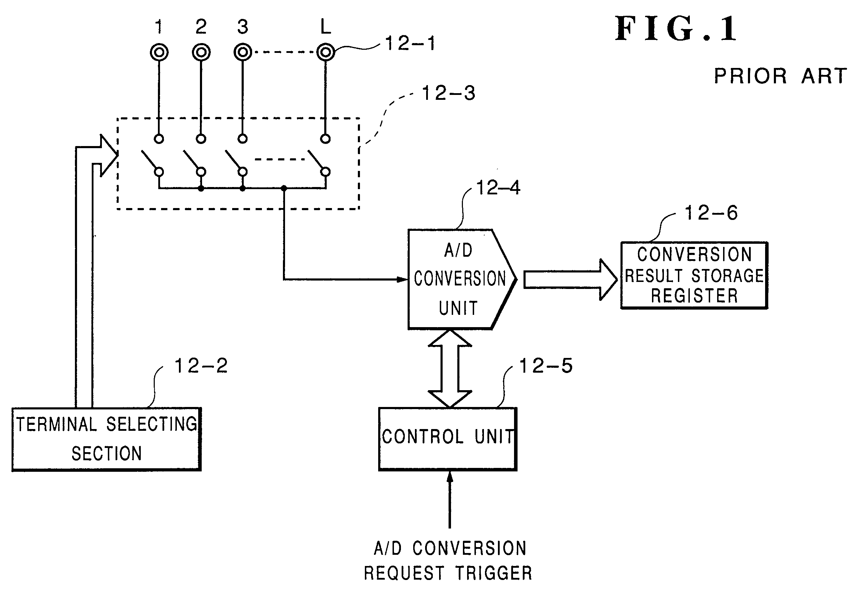

The conventional A/D converter has, in general, an arrangement as shown in FIG. 1 where typical operational sequences are divided into the following two cases.

At first, a terminal required for A/D conversion is selected by a terminal selecting section 12-2 from a group of L pieces of analog input terminals 12-1. Voltage applied to the selected analog input terminal is supplied to an A/D conversion unit 12-4 through a switching section 12-3 for generation of an A/D conversion request trigger which is a signal to be generated by a request for starting A/D conversion or to be automatically generated in case any satisfactory condition has been established on the hardware. When the A/D conversion request trigger is supplied to an A/D conversion request trigger control unit 12-5 to carry out a sequence control operation thereof for commencement of A/D conversion and after completion of the A/D conversion, the converted result is stored in a conversion result storage register 12-6. The converted result stored in the conversion result storage register 12-6 is read out by the software to terminate series of the works.

It is considered about the case where while the A/D conversion of the terminals selected by the terminal selecting section 12-2 is repeatedly carried out, a resultant value of A/D conversion is urgent to be obtained in case where a terminal other than terminals selected by the terminal selecting section 12-2 is temporarily selected to perform the A/D conversion and also to obtain an A/D conversion value in emergency.

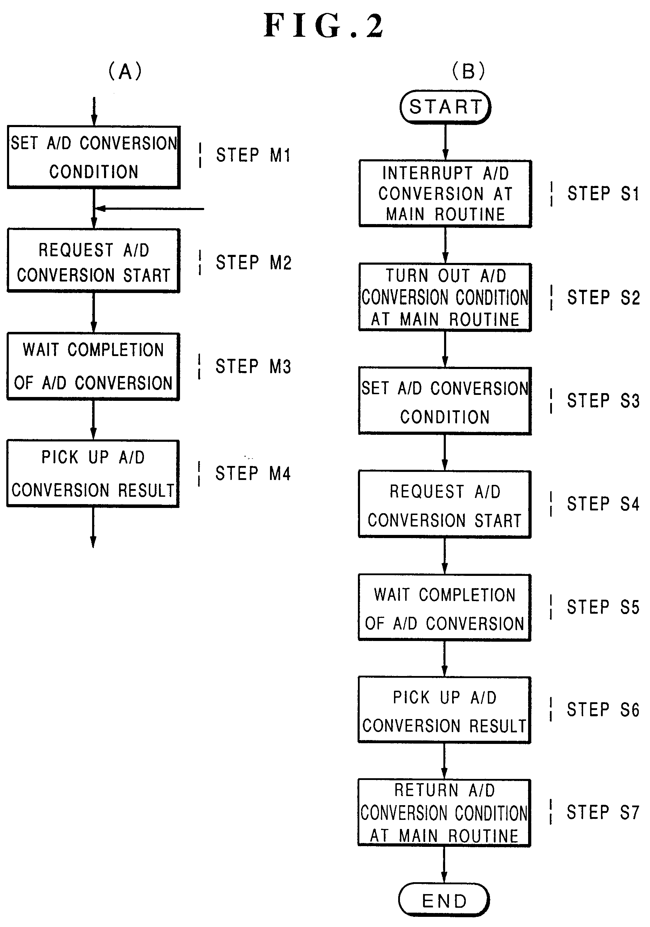

FIG. 2 is a flowchart of a series of works by means of the software for executing the A/D conversion, in which the flow (A) is an A/D conversion process of the terminal selected by the terminal section 12-2. The flow (B) is the A/D conversion process of the terminal other than that selected by the terminal selecting section 12-2, which is read out and executed upon execution of the flow (A).

It is further considered about the case where while processes indicating the Steps M2 to M4 of the flow (A) are repeatedly executed, the flow (B) is executed and then turned to the flow (A). In this process, an execution of the flow (B) which is read out through the flow (A) should not destruct setting in the flow (A). In the flow (B), turn-out and return processing for the condition in the flow (A) are required to perform by means of the steps S2 and S7. Moreover, because of the grater emergency in execution of the flow (B) than that of Flow (A), the A/D conversion executed in the flow (A) is interrupted while the processing of the flow (B) should rapidly be started. For such processing, in the step S1, A/D conversion of the flow (A) is interrupted. Then, the steps are processed, for example, by the step S3 to set the terminal intended to perform the A/D conversion in emergency for the commencement of the A/D conversion by means of S4. After completion of the A/D conversion, the stored value of the conversion result storage register 12-6 is read out at the in step S6 and the process is returned to the flow (A) through the returning a procedure of the step 7 as hereinbefore described. The explanation about the processing of result of the A/D conversion obtained at the flow (B) has been omitted.

Secondly, all of analog input terminals are set in the terminal selecting section 12-2. In this process, when a start of the A/D conversion is once required, all of the analog input terminals are sequentially A/D converted without any change of the setting condition but with an inevitable performance of the A/D conversions including the terminal necessary for the A/D conversion in the order of the sequential processing.

The conventional A/D converter entails many disadvantages as described hereinafter. In the two means for executing A/D conversions of different terminals with a set of the A/D converters which were referred to as the conventional technique, the first one requires many processings with respect to the software with an obvious low speed of the processing and difficulty in performing the processing in emergency. Further, on account of the decision and the process with the software, upon repeated execution of the A/D conversions, there are uneven times between the time where the A/D conversion is required and the time when the conversion value is actually obtained. Moreover, a large amount of the processing is required with erroneous operations occurable upon programming.

In the latter of two means described, the processing for the software are a few. If, however, there are many analog input terminals to be A/D converted, an executing period of the A/D conversion processing of a particular terminal would be extended, so that a considerable time is required for the period from the instant where the A/D conversion is required to the instant where the conversion value is actually obtained with considerable evenness in times before the A/D conversion value is obtained.

The foregoing disadvantages may be solved by the conventional techniques with two A/D converters in which one is used in an ordinary manner while the other usually placed under the standby condition is used only in emergency. The arrangement thus allows the A/D converter placed under the standby condition to response to the A/D conversion start request at a short time from the request.

The arrangement intends to process separately a terminal which needs to obtain the A/D conversion value with a high priority and the other terminals free of such need, thereby to improve the responsibility and the time dispersion before the A/D conversion value is determined. The arrangement of the type described seems very convenient in use for the customers, notwithstanding a relatively larger scale is required for the A/D converter even with a single circuit. Preparation of the A/D converter of two circuits is therefore not practical on account of high cost.

An A/D converter in accordance with the invention is comprised of a single A/D conversion unit, L pieces of analog input terminals, M pieces of terminal selecting sections for selecting one input terminal or a plurality of input terminals separately from the input terminal of L pieces, a switching section for switching terminals in accordance with the instructions from the terminal selecting sections of M pieces conversion result storage registers of M pieces for storing A/D convered request of analog voltage to be applied to analog input terminals selected by terminal selecting sections of M pieces, A/D conversion requested trigger input of M pieces, and a control unit for controlling an A/D conversion sequence.

The control unit operates according to the following sequences. At first, the A/D conversion of analog voltage applied to the analog input terminal selected by the Nth terminal selecting section is commenced by the Nth $(1 < = N < = M)$ A/D conversion request trigger. Then, when the A/D conversion takes place with the Hth $(1 < = N < = M)$ A/D conversion request trigger, the first $(H < 1 < = M)$ A/D conversion request trigger is supplied to interrupt an execution of A/D conversion for subsequent commencement of the A/D conversion of analog voltage applied to the analog digital input terminal selected by the first terminal selecting section. Further, when the A/D conversion takes places with the Jth $(1 < = J < = M)$ A/D conversion request trigger, the Kth $(1 < = K < J)$ A/D conversion request trigger is supplied to complete the A/D conversion without interruption.

Preferred embodiments of a method of producing an optical integrated circuit according to the present invention will hereinafter fully be described in detail with reference to the accompanying drawings.

FIG. 1 is a block diagram showing a arrangement example of the conventional A/D converter;
FIG. 2 is a flowchart of a arrangement example of the conventional A/D converter;
FIG. 3 is a block diagram illustrative of an embodiment of an A/D converter in accordance with the present invention;
FIG. 4 is a time chart showing an operational example of the embodiment of FIG. 3;
FIG. 5 is a time chart showing another operational example of the embodiment of FIG. 3;
FIG. 6 is a time chart showing further another operational example of the embodiment of FIG. 3;
FIG. 7 is a time chart showing still another operational example of the embodiment of FIG. 3;
FIG. 8 is a processing flowchart of the embodiment of FIG. 3;
FIG. 9 is a time chart showing another operational example of the embodiment of FIG. 3;
FIG. 10 is a time chart showing another operational example of another embodiment;
FIG. 11 is a time chart showing further another operational example of another embodiment;
FIG. 12 is a time chart showing still another operational example of another embodiment; and
FIG. 13 is a flowchart of another embodiment.

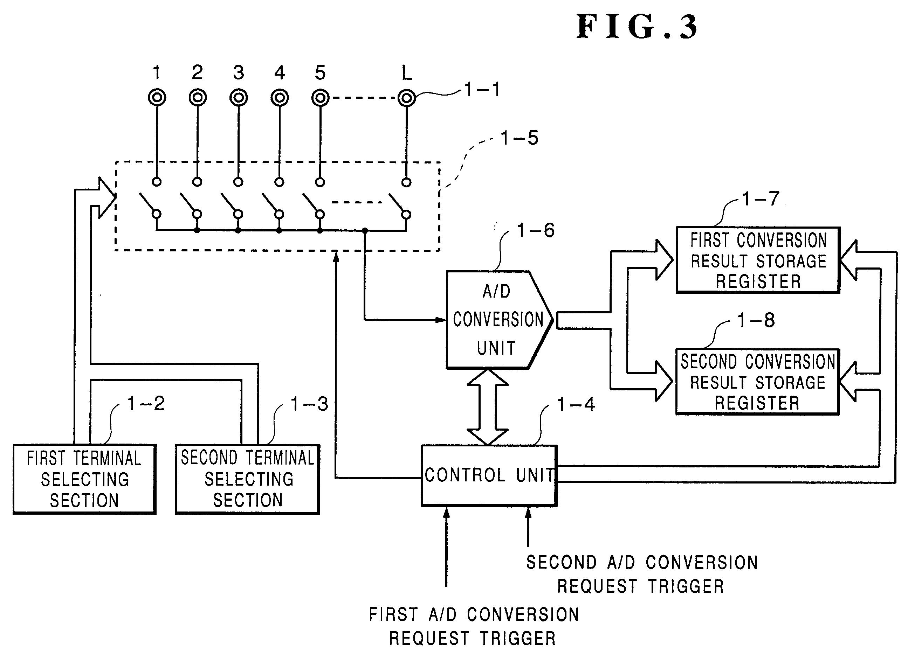

In FIG. 3, a value of M is equal to 2 and an operation of the block diagram is separated into the following four operations.

In the first operation, to execute A/D conversion, a terminal to be A/D converted by the first A/D conversion request trigger and selected from a group of L pieces of analog input terminals 1-1 is set in the first terminal selecting section 1-2, while another terminal to be A/D converted by the second A/D conversion request trigger is set in the second terminal selecting section 1-3. In the embodiment, the first terminal selecting section 1-2 is set with the terminal number 1 and the second terminal selecting section 1-3 is set with the terminal number 2. Those numbers set are commonly used for four explanations of the first to fourth operations.

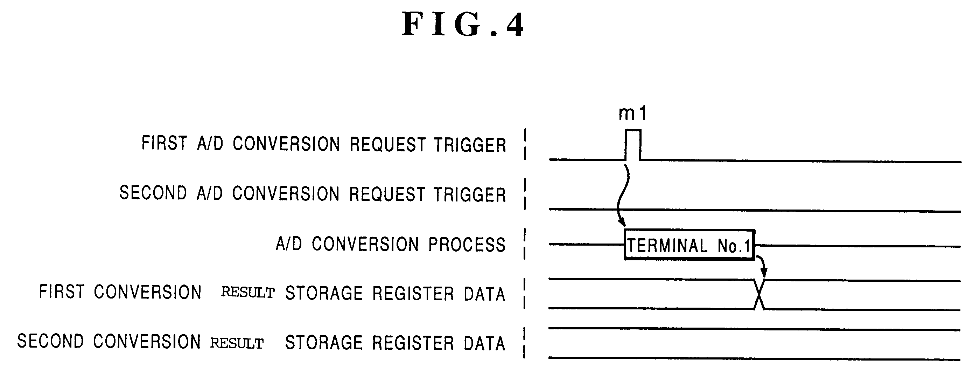

As shown in FIG. 4, the first A/D conversion request trigger m1 only is generated. This means that the second A/D conversion request trigger is never allowed to generate. Conceivable means for generating an A/D conversion request trigger may be of a means for generating an A/D conversion start request by the software instruction or of a means for automatically generating by the hardware processing upon fulfillment of some available conditions. The present examples will be described hereinafter about generation of the A/D conversion request trigger by the instruction of software. A control unit 1-4 receives the first A/D conversion request trigger and instructs the switching section 1-5 to make the terminal selected by the first terminal selecting section 1-2 or the terminal number 1 effective for supplying a voltage applied to the terminal number 1 to the A/D conversion unit 1-6. The control unit 1-4 then instructs the A/D conversion unit 1-6 to start an execution of the A/D conversion. After completion of the A/D conversion, the control unit 1-4 instructs the first conversion result storage register 1-7 to renew the present storage value with the just completed A/D conversion value. At this time, the second conversion result storage register 1-8 holds a previous value without renewing any value. Finally, the A/D conversion value is red out to terminate the series of works.

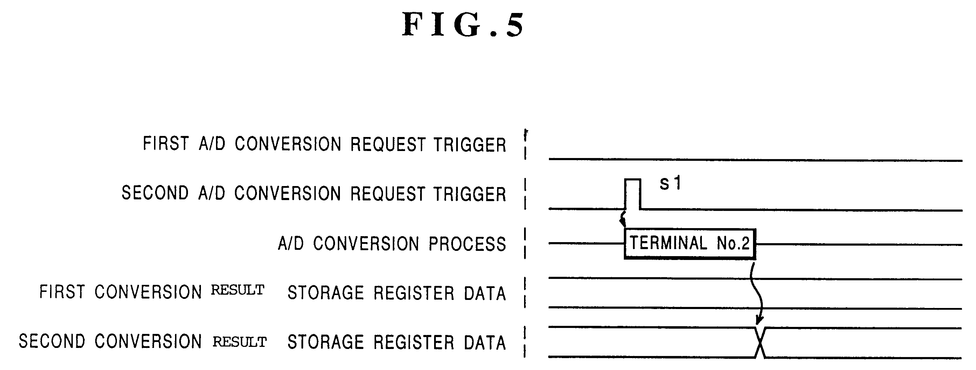

In the second operation, only the second A/D conversion request trigger s1 is generated as shown in FIG. 5. This means that the first A/D conversion request trigger is never allowed to generate. The control unit 1-4 receives the second A/D conversion request trigger and instructs the switching section 1-5 to make the terminal selected by the second terminal selecting section 1-3 or the terminal number 2 effective for supplying a voltage applied to the terminal number 2 to the A/D conversion unit 1-6. The control unit 1-4 then instructs the A/D conversion unit 1-6 to start an execution of the A/D conversion. After completion of the A/D conversion, the control unit 1-4 instructs the second conversion result storage register 1-8 to renew to the present storage value with the just completed A/D conversion value. At this time, the first conversion result storage register 1-7 holds a previous value without renewing any value.

The two operations hereinbefore described have no substantial difference from the conventional examples for individual operation where a generation of the A/D conversion request trigger is limited to only one.

In the third operation, an operational sequence constitutes a feature of the invention.

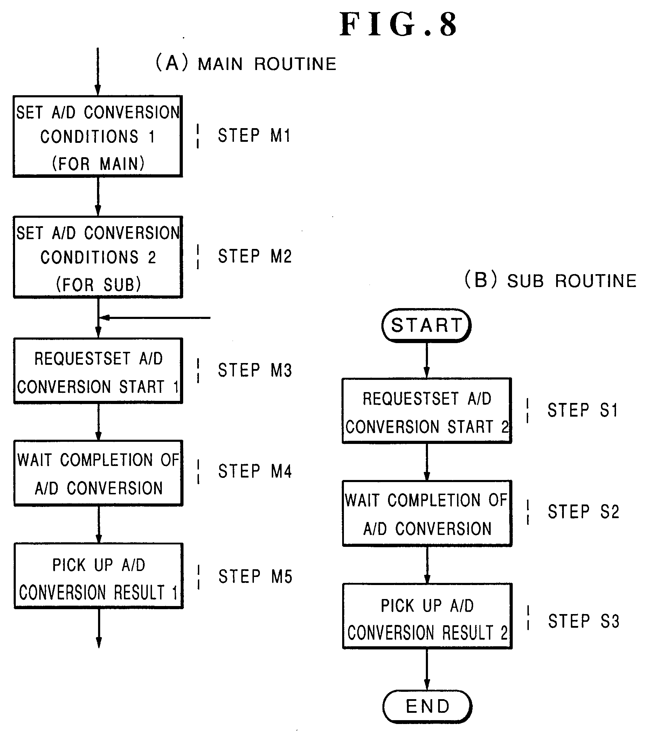

In FIG. 8, the second A/D conversion request trigger is applied while the A/D conversion is executed by the the A/D conversion request trigger. For example, in the flow (A) of FIG. 8, settings of A/D conversion conditions such as setting of the first terminal selecting section 1-2, setting of the second terminal selecting section 1-3, and initial setting required for the other A/D conversion take place at the steps M1 and M2. In the step M3, the first A/D conversion request trigger is generated, and upon termination of execution of the A/D conversion at the step M4, the converted result of A/D conversion is pick up at the step M5.

In the continued sequence, the flow (B) is called on execution of the step M4.

A call of the flow (B) is carried out by the branching process upon determination of fulfill of the predetermined conditions during execution of the flow (A) or by so called interrupting process. In the example, the calling of the flow (B) is assumed to be performed by the branching process through with a program when the predetermined conditions are fulfilled.

The process is transferred to the flow (B) and when the A/D conversion of the terminal other than the terminal selected by the first terminal selecting section takes place, a terminal information to be A/D converted at the flow (A) is set to the first terminal selecting section, while the terminal information to be A/D converted at at the flow (B) is set to the second terminal selecting section. Thus, the conventionally required turn-out or return of condition for the A/D conversion in the flow (A) fell into disuse. When the second A/D conversion request trigger is supplied, the control unit 1-4 operates to carry out a sequence control for interruption of the A/D conversion by the first A/D conversion request trigger and subsequent commencement of the A/D conversion by the second A/D conversion request trigger. In the flow (B), an interrupt processing of the A/D conversion with the first A/D conversion request trigger may thus be omitted. Accordingly, just after the shift to the flow (B), a request for starting the A/D conversion may be delivered to a terminal selected by the second terminal selecting section 1-3, enabling to generate the second A/D conversion request trigger.

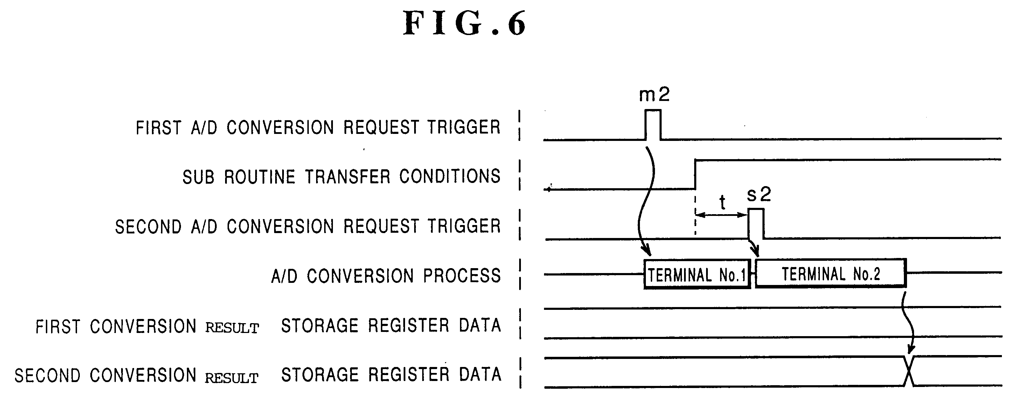

In FIG. 6, when the A/D conversion takes place with the first A/D conversion request trigger m2 and the second A/D conversion request trigger is supplied to the control unit 1-4 of FIG. 3, the control unit 1-4 instructs the A/D conversion unit 1-6 to interrupt the A/D conversion under execution and in turn instructs the switching section 1-5 to make the terminal selected by the first terminal selecting section 1-2 or the terminal number 1 ineffective but to make another terminal selected by the second terminal selecting section 1-3 or the terminal number 2 effective. Thus, a voltage to be applied to the terminal number 2 may be supplied to the A/D conversion unit 1-6 and the control unit 1-4 instructs the A/D conversion unit 1-6 to start an execution of the A/D conversion. After completion of the A/D conversion, the control unit 1-4 instructs the second conversion result storage register 1-8 to renew the present storage value by the just obtained A/D conversion value. Once started A/D conversion by the first A/D conversion request trigger is interrupted so that the first conversion result storage register 1-7 is not renewed, storing the A/D conversion result of one step before.

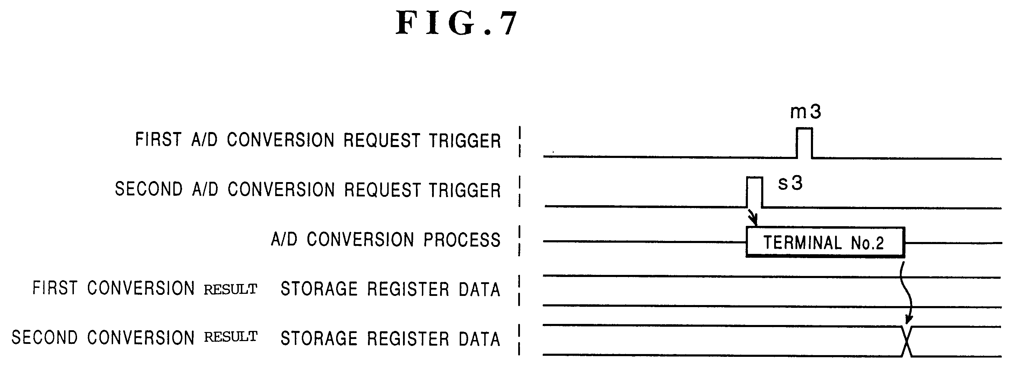

In the fourth operation, the flowchart of FIG 7 shows such situation that the first A/D conversion request trigger m3 is given while the A/D conversion takes place by the second A/D conversion request trigger s3 where in case the first A/D conversion request trigger is periodically generated irrespective of the flow of the program, the third example processing hereinbefore described intervenes and before such processing terminates, the first A/D conversion request trigger is generated.

In the third operation, the second A/D conversion request trigger is predominated than the first A/D conversion request trigger as one of the characteristic features of the invention, notwithstanding to obtain more perfect result, the A/D conversion processing with the second A/D conversion request trigger should preferably be continued to its completion. Thus, as shown in FIG. 7, the control unit 1-4 is requested to have such function that any supply of the first A/D conversion request trigger should never be received during execution of the A/D conversion processing with the second A/D conversion request trigger.

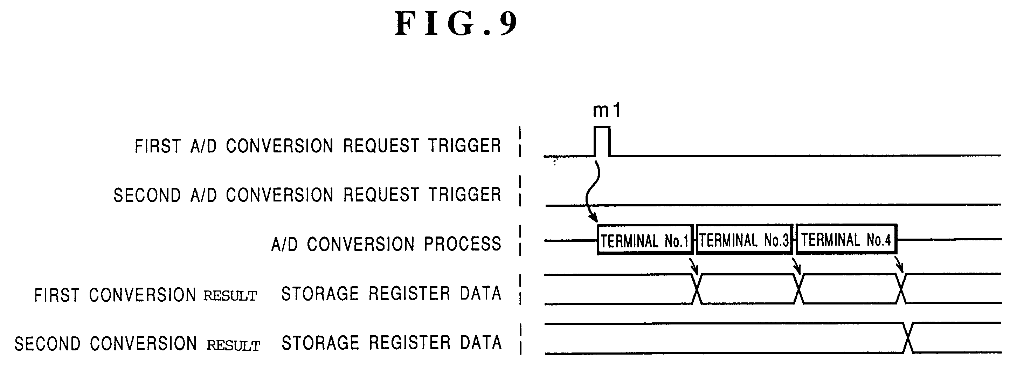

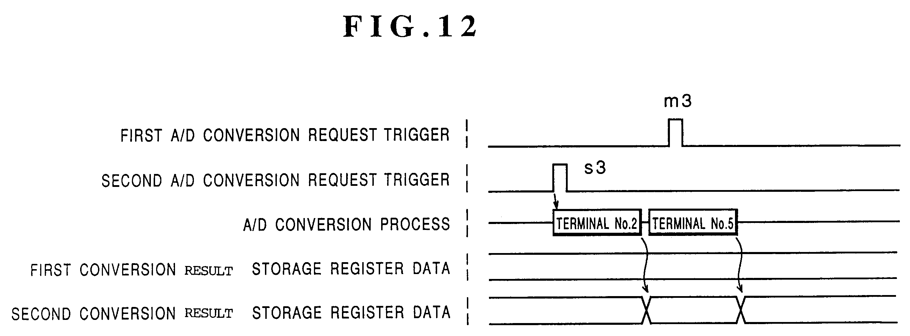

Another embodiment of the invention will be described with reference to FIG. 3 wherein an operation is divided into four cases like the first embodiment, providing a value of M as 2. Operational timings are different from the first embodiment as shown in FIGS. 9 and 12 with the charts.

In the first operation, to execute the A/D conversion, a terminal to be A/D converted by the first A/D conversion request trigger is selected from a group of L pieces of analog input terminals 1-1 for setting in the first terminal selecting section 1-2. Another terminal to be A/D converted by the second A/D conversion request trigger is set in the second terminal selecting section 1-3. In the example, a plurality of terminals are set respectively, and those set terminals are sequentially converted by the A/D conversion request trigger generated at a time and the first terminal selecting section 1-2 is identified with the terminal numbers 1, 3 and 4, while the second terminal section 1-3 is identified by the terminal numbers 2 and 5.

In FIG. 9, the first A/D conversion request trigger m1 only is generated. In the example, there is provided a means for generating the A/D conversion request trigger automatically with a hardware processing upon fulfillment of the predetermined conditions. The control unit 1-4 receives the first A/D conversion request trigger and then instruct the switching section 1-5 to sequentially make terminals selected by the first terminal selecting section 1-2 or the terminal numbers 1, 3 and 5 effective. A voltage applied to the terminal number 1 is initially supplied to the A/D conversion unit 1-6. The control unit 1-4 instructs the A/D conversion unit 1-6 to start an execution of the A/D conversion. After completion of the A/D conversion, the control unit 1-4 instructs the first conversion result storage register 1-7 to renew the present storage value by the converted value of the just completed A/D conversion. The voltage applied to the terminal 3 in place of the terminal 1 is supplied to the A/D conversion unit 1-6 through the switching section 1-5, and the control unit 1-4 instructs the A/D conversion unit 1-6 to start an execution of the A/D conversion. After completion of the A/D conversion, the control unit 1-4 instructs again the first conversion result storage register 1-7 to renew the stored value. The same process is executed for the terminal 4. At this time, the second conversion result storage register 1-8 is kept to hold a previous value. In this operation, since the stored value of the first conversion result storage register is renewed by the A/D conversion value of different terminals upon each time the A/D conversion is completed, the stored value is required to be picked up at every renew time.

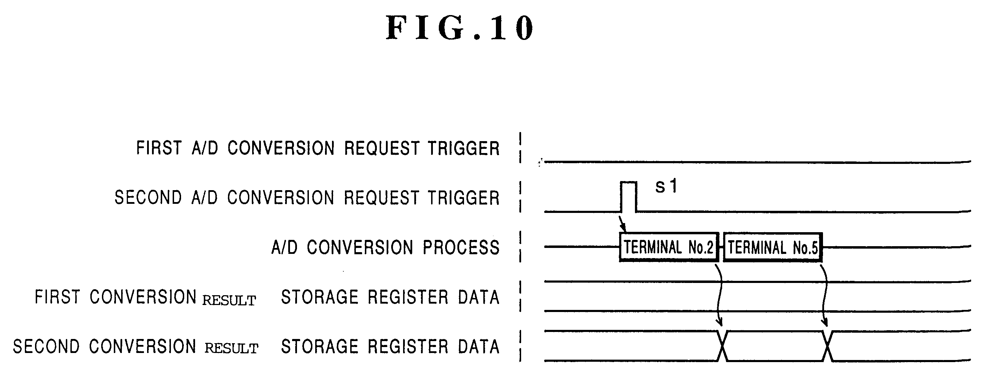

In the second operation, the second A/D conversion request trigger s1 in FIG. 10 only is generated. The control unit 1-4 renews the second A/D conversion request trigger and instructs the switching section 1-5 to sequentially make terminals selected by the second terminal selecting section 1-3 or the terminal numbers 2 and 5 effective. The voltage applied to the terminal number 2 is supplied to the A/D conversion unit 1-6 and then the control unit 1-4 instructs the A/D conversion unit 1-6 to start an execution of the A/D conversion. After completion of the A/D conversion, the control unit 1-4 instructs the second conversion result storage register 1-8 to renew the present storage value. The voltage applied to the terminal 5 in place of the terminal 2 is supplied to the A/D conversion unit 1-6 through the switching section 1-5, and the control unit 1-4 instructs the A/D conversion unit 1-6 to start an execution of the A/D conversion. After the completion of the A/D conversion, the control unit 1-4 again instructs the first conversion result storage register 1-7 to renew the stored value. At this time, the first conversion result storage register 1-7 maintains a previous value without change.

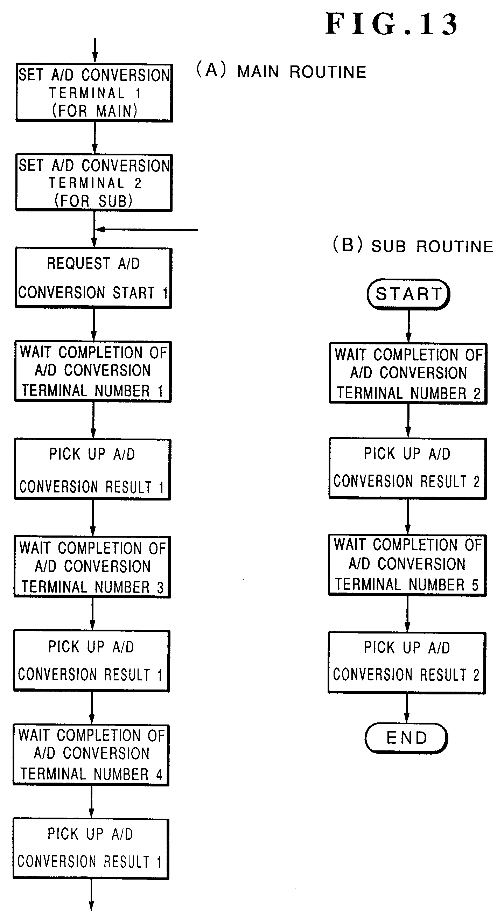

In the third operation as shown in FIG. 13, the second A/D conversion request trigger is supplied upon execution of the A/D conversion with the first A/D conversion request trigger where the interrupt condition is fulfilled by a hardware on the process of the program execution of the flow (A) of FIG. 13 to shift the processing to the flow (B) for execution of the A/D conversion.

The turn-out and return a condition for the A/D conversion of the flow (A) as required in the conventional examples fell into disuse as hereinbefore described in the first example. Interrupt processing of A/D conversion by the first A/D conversion request trigger fell also into disuse. Further since the second A/D conversion request trigger is automatically generated upon request of interrupt by the hardware, the A/D conversion start request by the software is no more required.

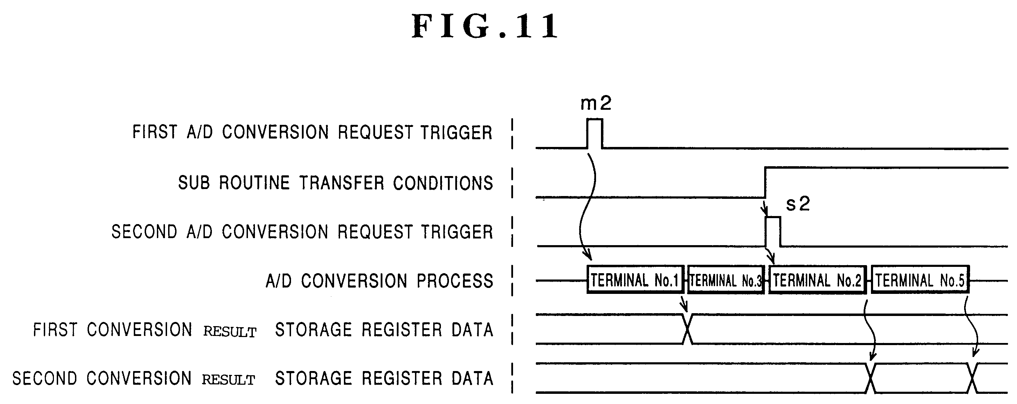

In FIG. 11, the second A/D conversion request trigger s2 is supplied to the control unit 1-4 during execution of A/D conversion of the terminal 3 on the process where the terminal numbers 1, 3 and 5 are sequentially A/D converted by the first A/D conversion request trigger m2. Then, the control unit 1-4 instructs the A/D conversion unit 1-6 to interrupt the A/D conversion under execution. The control unit 1-4 instructs the switching section 1-5 to make terminal selected by the first terminal selecting section 1-2 or the terminal number 3 ineffective and to make the terminal selected by the second terminal selecting section 1-3 or the terminal number 2 effective. Thus, the voltage applied to the terminal number 2 is supplied to the A/D conversion unit 1-6 and the control unit 1-4 instructs the A/D conversion unit 1-6 to start an actuation of A/D conversion. After completion of the A/D conversion, the control unit 1-4 instructs the second conversion result storage register 1-8 to renew the present storage value by the converted value of the just completed A/D conversion. The A/D conversion once started by the first A/D conversion request trigger is interrupted during conversion of the terminal number 3. Thus, the first A/D conversion result storage register 1-7 is not renewed and the A/D conversion result of the terminal 1 remains stored.

Finally, in the fourth operation, the first A/D conversion request trigger m3 is supplied during execution of A/D conversion by the second A/D conversion request trigger s3 of FIG. 12 like the first embodiment. In this example, the control unit 1-4 is also provided with such function that the control unit 1-4 does never receive the first A/D conversion request trigger m3 during execution of the A/D conversion of the second A/D conversion request trigger s3.

For better understanding, an operational sequence of the control unit will be described hereinafter. At first, by the first A/D conversion request trigger, the A/D conversion of an analog voltage to be applied to an analog input terminal selected by the second terminal selecting section is started. Further, by the second A/D conversion request trigger, the second A/D conversion request trigger is supplied on execution of the A/D conversion to interrupt the A/D conversion under execution so that the A/D conversion of analog voltage, which is applied to an analog input terminal selected by the second terminal selecting section, is started. An further, by the second A/D conversion request trigger, the first A/D conversion request trigger is supplied on execution of the A/D conversion, so that at least the A/D conversion under execution is interrupted until completion of the conversion.

As hereinbefore fully described, in accordance with the first embodiment of the present invention, unlike the conventional complicated procedure, the A/D conversion with the temporary interrupt processing and change of selection of analog input terminals may be carried out conveniently. Thus, the period from the instant when an A/D conversion value of the terminal selected by the second terminal selecting section is required to the instant when the converted value is actually obtained may considerably be reduced. Since the A/D conversion result storage register is prepared at every terminal selecting section, the stored value of the first conversion result storage register is never destructed broken by the A/D conversion with the second A/D conversion request trigger, and at any time, the last A/D conversion value of the terminal selected by the first terminal selecting section may be picked up. Any evaluation is not necessary to determine whither the A/D conversion result is brought from the flow (A) or from the flow (B). The first conversion result storage register is sometime not renewed by one time or is delayed. This is however substantially the same as the converted result is submitted to the customer's observation before completion of conversion in view point of the customer on an actual problem.

In the first operation processes of the transition to the flow (B) and the generation of the second A/D conversion request trigger are executed by a software. Thus, a delay time "t" of FIG. 6 is caused under the condition of transmission to the flow (B) or the period from the instant when the A/D conversion value of the terminal selected by the second terminal selecting section is required to the instant when the second A/D conversion request trigger is generated. The delay time "t" is staggered in value.

Accordingly, in the second operation, fulfillment of such transition condition to the flow (B) is determined by a hardware to carry out the transition to the flow (B) and the generation of the second A/D conversion request trigger, so that the delay time "t" from the transition against the flow (B) to the generation of second A/D conversion request trigger is negligible as shown in FIG. 11, with the minimized staggering. This provides such advantage that when the voltage applied to the analog input terminal is varied with time lapse, an A/D conversion value after a predetermined time lapses from fulfillment of the transition condition against to the flow (B) may be obtained.

The foregoing advantages will be attainable with use of two units of the A/D conversions, notwithstanding the present invention is still particularly meritorious in execution of the A/D conversion with a smaller arrangement.

**Claims**

**1.** An A/D converter which is comprised of a single analog/digital conversion unit (1-6), L pieces of analog input terminals (1-1), M pieces of terminal selecting sections (1-2, 1-3) for selecting separately any input terminal or a plurality of input terminals from said input terminals, a switching section (1-5) for switching terminals upon selection by M pieces of terminal selecting sections, M pieces of conversion result storage registers (1-7, 1-8) for storing analog/digital converted result of analog voltage applied to analog input terminals selected by said M pieces of terminal selecting sections respectively, M pieces of analog/digital conversion request trigger input, and a control unit (1-4) for controlling an analog/digital conversion sequence.

2. An analog/digital converter as claimed in claim 1, characterized in that analog/digital conversion of analog voltage applied to an analog input terminal selected by the Nth terminal selecting section is started by the Nth (1 < N < = M) analog/digital conversion trigger.

3. An analog/digital converter as claimed in claim 1, characterized in that during analog/digital conversion by the Hth (1 < = H < = M) analog/digital conversion request trigger, when the first (H < 1 < = M) analog/digital conversion request trigger is applied, an analog/digital conversion under execution is interrupted, an analog/digital conversion of the analog voltage applied to an analog digital input terminal selected by the first terminal selecting section is started.

4. An analog/digital converter as claimed in claim 1, characterized in that during analog/digital conversion by the Jth (1 < = J <= M) analog/digital conversion request trigger, when the Kth (1 < = K < M) analog/digital conversion request trigger is applied, at least an analog/digital conversion under execution is not interrupted and is continued to be executed until completion of the conversion.

# FIG.1

PRIOR ART

EP 0 502 428 A2

# FIG.2

## (A)

SET A/D CONVERSION CONDITION ┊ STEP M1

REQUEST A/D CONVERSION START ┊ STEP M2

WAIT COMPLETION OF A/D CONVERSION ┊ STEP M3

PICK UP A/D CONVERSION RESULT ┊ STEP M4

## (B)

START

INTERRUPT A/D CONVERSION AT MAIN ROUTINE ┊ STEP S1

TURN OUT A/D CONVERSION CONDITION AT MAIN ROUTINE ┊ STEP S2

SET A/D CONVERSION CONDITION ┊ STEP S3

REQUEST A/D CONVERSION START ┊ STEP S4

WAIT COMPLETION OF A/D CONVERSION ┊ STEP S5

PICK UP A/D CONVERSION RESULT ┊ STEP S6

RETURN A/D CONVERSION CONDITION AT MAIN ROUTINE ┊ STEP S7

END

# FIG. 3

EP 0 502 428 A2

# FIG.4

FIRST A/D CONVERSION REQUEST TRIGGER

SECOND A/D CONVERSION REQUEST TRIGGER

A/D CONVERSION PROCESS

FIRST CONVERSION RESULT STORAGE REGISTER DATA

SECOND CONVERSION RESULT STORAGE REGISTER DATA

m1

TERMINAL No.1

EP 0 502 428 A2

# FIG.5

FIRST A/D CONVERSION REQUEST TRIGGER

SECOND A/D CONVERSION REQUEST TRIGGER

s1

A/D CONVERSION PROCESS — TERMINAL No.2

FIRST CONVERSION RESULT STORAGE REGISTER DATA

SECOND CONVERSION RESULT STORAGE REGISTER DATA

EP 0 502 428 A2

# FIG.6

FIRST A/D CONVERSION REQUEST TRIGGER

SUB ROUTINE TRANSFER CONDITIONS

SECOND A/D CONVERSION REQUEST TRIGGER

A/D CONVERSION PROCESS — TERMINAL No.1 — TERMINAL No.2

FIRST CONVERSION RESULT STORAGE REGISTER DATA

SECOND CONVERSION RESULT STORAGE REGISTER DATA

m2   s2   t

EP 0 502 428 A2

# FIG.7

FIRST A/D CONVERSION REQUEST TRIGGER

SECOND A/D CONVERSION REQUEST TRIGGER

A/D CONVERSION PROCESS

FIRST CONVERSION RESULT STORAGE REGISTER DATA

SECOND CONVERSION RESULT STORAGE REGISTER DATA

m3

s3

TERMINAL No.2

EP 0 502 428 A2

# FIG.8

## (A) MAIN ROUTINE

```
SET A/D CONVERSION
  CONDITIONS 1        STEP M1
    (FOR MAIN)
```

```
SET A/D CONVERSION
  CONDITIONS 2        STEP M2
    (FOR SUB)
```

```
  REQUESTSET A/D
CONVERSION START 1    STEP M3
```

```
WAIT COMPLETION OF
  A/D CONVERSION      STEP M4
```

```
   PICK UP A/D
CONVERSION RESULT 1   STEP M5
```

## (B) SUB ROUTINE

( START )

```
  REQUESTSET A/D
CONVERSION START 2    STEP S1
```

```
WAIT COMPLETION OF
  A/D CONVERSION      STEP S2
```

```
   PICK UP A/D
CONVERSION RESULT 2   STEP S3
```

( END )

# FIG.9

FIRST A/D CONVERSION REQUEST TRIGGER

SECOND A/D CONVERSION REQUEST TRIGGER

A/D CONVERSION PROCESS

FIRST CONVERSION RESULT STORAGE REGISTER DATA

SECOND CONVERSION RESULT STORAGE REGISTER DATA

m1

TERMINAL No.1 | TERMINAL No.3 | TERMINAL No.4

EP 0 502 428 A2

# FIG.10

FIRST A/D CONVERSION REQUEST TRIGGER

SECOND A/D CONVERSION REQUEST TRIGGER

s1

A/D CONVERSION PROCESS

TERMINAL No.2  TERMINAL No.5

FIRST CONVERSION RESULT STORAGE REGISTER DATA

SECOND CONVERSION RESULT STORAGE REGISTER DATA

EP 0 502 428 A2

# FIG.11

EP 0 502 428 A2

# FIG.12

FIRST A/D CONVERSION REQUEST TRIGGER

SECOND A/D CONVERSION REQUEST TRIGGER

A/D CONVERSION PROCESS

FIRST CONVERSION RESULT STORAGE REGISTER DATA

SECOND CONVERSION RESULT STORAGE REGISTER DATA

m3

s3

TERMINAL No.2   TERMINAL No.5

EP 0 502 428 A2

# FIG.13

(A) MAIN ROUTINE

SET A/D CONVERSION
TERMINAL 1
(FOR MAIN)

↓

SET A/D CONVERSION
TERMINAL 2
(FOR SUB)

↓

REQUEST A/D
CONVERSION START 1

↓

WAIT COMPLETION OF
A/D CONVERSION
TERMINAL NUMBER 1

↓

PICK UP A/D
CONVERSION RESULT 1

↓

WAIT COMPLETION OF
A/D CONVERSION
TERMINAL NUMBER 3

↓

PICK UP A/D
CONVERSION RESULT 1

↓

WAIT COMPLETION OF
A/D CONVERSION
TERMINAL NUMBER 4

↓

PICK UP A/D
CONVERSION RESULT 1

↓

(B) SUB ROUTINE

( START )

↓

WAIT COMPLETION OF
A/D CONVERSION
TERMINAL NUMBER 2

↓

PICK UP A/D
CONVERSION RESULT 2

↓

WAIT COMPLETION OF
A/D CONVERSION
TERMINAL NUMBER 5

↓

PICK UP A/D
CONVERSION RESULT 2

↓

( END )

20